# EUROPEAN PATENT APPLICATION

(11) **EP 4 328 958 A1**
(43) Date of publication of application: **28.02.2024**
(21) Application number: 22791417.3
(22) Date of filing: 16.03.2022
(51) Int. Cl.: H01L 21/304

(54) **METHOD FOR PRODUCING SILICON WAFER**

(30) Priority: 21.04.2021 JP 2021072089
(71) Applicant: Shin-Etsu Handotai Co., Ltd., Tokyo 100-0004 (JP)
(72) Inventor: ABE, Tatsuo, Nishishirakawa-gun, Fukushima 961-8061 (JP); TANAKA, Yuki, Nishishirakawa-gun, Fukushima 961-8061 (JP)
(74) Representative: Sonnenhauser, Thomas Martin
(86) International application number: PCT/JP2022/011767
(87) International publication number: WO 2022/224637

(57) **Abstract**

The present invention is a silicon wafer manufacturing method including a grinding step of grinding front and back surfaces of a raw wafer to obtain a wafer having an arithmetic surface roughness Sa per 2 µm² of 10 nm or less; a dry-etching step of subjecting the wafer obtained in the grinding step to isotropic whole-surface dry-etching with an etching removal of 1 um or less per surface to remove a mechanically damaged layer introduced into each of front and back surfaces of the wafer in the grinding step; and a double-side polishing step of, after the dry-etching step, polishing both surfaces of the wafer with a stock removal of 3 um or less per surface. Thus, the silicon wafer manufacturing method that enables to manufacture a wafer having high flatness can be provided.

## Description

### TECHNICAL FIELD

The present invention relates to a silicon wafer manufacturing method.

### BACKGROUND ART

In a method of manufacturing silicon wafers for semiconductors, a grinding process is used particularly as a flattening technique. A surface of the silicon wafer after this grinding process has a mechanically damaged layer formed thereon due to the mechanical grinding process. To remove such a mechanically damaged layer, an etching process with a mixed acid or an alkaline liquid is performed.

However, it is difficult to uniformly etch the whole surface of the wafer by the mixed-acid etching process, which thus causes a problem of deterioration of flattening.

Further, in alkali etching, surface roughness is deteriorated and deep pits are formed, due to anisotropic etching. To remove such surface roughness and deep pits, a large amount of stock removal is required in the subsequent polishing step, which causes a problem of reduction in productivity.

In addition, etching with a mixed acid or alkali uses a large amount of chemicals, which involves problems of environmental burden and cost increase caused by exhaust-gas treatment, wastewater treatment, and the like.

Patent Document 1 describes that plasma-assisted etching is performed after grinding, and further flatness is corrected by local plasma-assisted etching, followed by polishing to manufacture a silicon wafer having good flatness.

Patent Document 2 describes a method of performing plasma etching on one surface, in which, according to the thickness distribution of silicon wafer measured in advance, the plasma-etching removal is adjusted for flattening.

Patent Document 3 discloses a wafer manufacturing method in which the shape of a silicon wafer is measured after slicing and chamfering steps, the back side is flattened by plasma etching based on the measurement results, then the front side is ground and further polished.

In addition, Patent Documents 4 to 10 also disclose a semiconductor wafer manufacturing method in which dry etching using plasma, dry etching, or vapor-phase etching is performed.

### CITATION LIST

### PATENT LITERATURE

Patent Document 1: JP 2000-12411 A
Patent Document 2: JP 2001-185537 A
Patent Document 3: JP 2004-63883 A
Patent Document 4: JP H09-260314 A
Patent Document 5: JP 2001-244240 A
Patent Document 6: JP 2008-153404 A
Patent Document 7: JP H09-266186 A
Patent Document 8: JP 2001-110767 A
Patent Document 9: JP 2019-110213 A
Patent Document 10: JP 2019-169694 A

### SUMMARY OF INVENTION

### TECHNICAL PROBLEM

In a conventional wafer process, an etching treatment with a mixed acid or alkali is performed after grinding in order to remove impurities and mechanical damage. However, mixed-acid etching deteriorates flatness due to non-uniform etching, and alkali etching deteriorates surface roughness and forms deep pits. These cause deterioration of flatness due to an increase in stock removal of double-side polishing. That is, deterioration of flatness caused by mixed-acid etching and alkali etching is a problem.

In addition, this wet etching involves problems of cost and environmental burden caused by large amounts of chemicals and exhaust gas and wastewater treatment.

Further, even in the case of using dry etching instead of mixed-acid etching and alkali etching, the actual circumstance is that improvement of productivity by virtue of sufficient reduction in stock removal, and high flatness cannot be achieved.

The present invention has been made in view of the above problems, and an object thereof is to provide a silicon wafer manufacturing method that enables to manufacture a wafer having high flatness.

### SOLUTION TO PROBLEM

To solve the above problems, the present invention provides a silicon wafer manufacturing method comprising:
a grinding step of grinding front and back surfaces of a raw wafer to obtain a wafer having an arithmetic surface roughness Sa per 2 µm² of 10 nm or less;
a dry-etching step of subjecting the wafer obtained in the grinding step to isotropic whole-surface dry-etching with an etching removal of 1 um or less per surface to remove a mechanically damaged layer introduced into each of front and back surfaces of the wafer in the grinding step; and
a double-side polishing step of, after the dry-etching step, polishing both surfaces of the wafer with a stock removal of 3 um or less per surface.

With such a wafer manufacturing method of the present invention, the mechanically damaged layer can be removed without deteriorating good flatness after the grinding, and stock removal can also be reduced, so that it is possible to manufacture a wafer having high flatness with high productivity. In addition, it is not necessary to perform wet etching, so that it is possible to reduce cost and environmental burden caused by large amounts of chemicals and exhaust gas used in etching with a mixed acid or alkali, and wastewater treatment.

Preferably, in the dry-etching step, an etching rate is 0.3 µm/min or less.

This enables to manufacture a wafer having high flatness while more reliably preventing deterioration of good flatness after the grinding.

Preferably, in the dry-etching step, a front-back surface oxidation treatment with ozone (O₃) gas is performed as a pre-treatment of the isotropic whole-surface dry-etching.

In this way, performing the front-and-back surfaces oxidation treatment in the ozone atmosphere before the isotropic whole-surface dry-etching enables to easily remove organic substances adhered to the front and back surfaces of the wafer.

Preferably, in the dry-etching step, a front-and-back surfaces oxidation treatment with ozone (O₃) gas is performed as a post-treatment of the isotropic whole-surface dry-etching.

In this way, performing the front-and-back surfaces oxidation treatment in the ozone atmosphere after the isotropic whole-surface dry-etching enables to easily form an oxide protection film on each of the front and back surfaces of the wafer.

### ADVANTAGEOUS EFFECTS OF INVENTION

As above, with the wafer manufacturing method of the present invention, the mechanically damaged layer can be removed without deteriorating good flatness after the grinding, which enables to manufacture a wafer having high flatness with high productivity. In addition, it is not necessary to perform wet etching, which enables to reduce cost and environmental burden caused by large amounts of chemicals and exhaust gas used in etching with a mixed acid or alkali, and wastewater treatment.

### BRIEF DESCRIPTION OF DRAWINGS

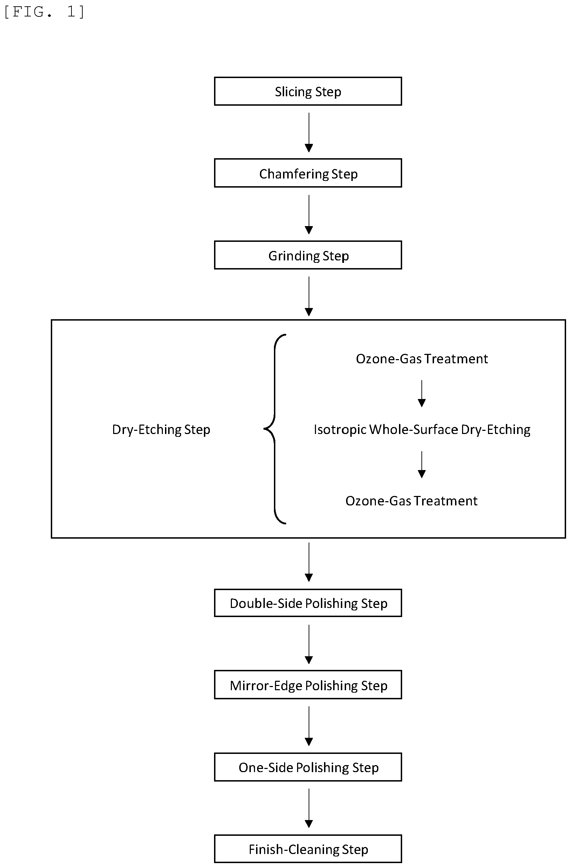

FIG. 1 is a flow diagram illustrating an example of a wafer manufacturing method of the present invention.

### DESCRIPTION OF EMBODIMENTS

As described above, development of a silicon wafer manufacturing method that enables to manufacture a wafer having high flatness has been demanded.

As a result of repeated earnest studies of the above problems, the present inventors have found that, by obtaining a wafer having an arithmetic surface roughness Sa per 2 µm² of 10 nm or less through a grinding step, subjecting the wafer to isotropic whole-surface dry-etching with an etching removal of 1 um or less per surface to remove a mechanically damaged layer, then polishing both surfaces of the wafer with a stock removal of 3 um or less per surface in a double-side polishing step, the mechanically damaged layer can be removed without deteriorating good flatness after the grinding, which enables to manufacture a wafer having high flatness with high productivity. With this finding, the present inventors have completed the present invention.

That is, the present invention is a silicon wafer manufacturing method comprising:
a grinding step of grinding front and back surfaces of a raw wafer to obtain a wafer having an arithmetic surface roughness Sa per 2 µm² of 10 nm or less;
a dry-etching step of subjecting the wafer obtained in the grinding step to isotropic whole-surface dry-etching with an etching removal of 1 um or less per surface to remove a mechanically damaged layer introduced into each of front and back surfaces of the wafer in the grinding step; and
a double-side polishing step of, after the dry-etching step, polishing both surfaces of the wafer with a stock removal of 3 um or less per surface.

It should be noted that Patent Documents 1 to 10 disclose a semiconductor wafer manufacturing method in which dry etching using plasma, dry etching, or vapor-phase etching is performed; however, none of those documents describe or suggest obtaining a wafer having an arithmetic surface roughness Sa per 2 µm² of 10 nm or less through a grinding step, subjecting the wafer to isotropic whole-surface dry-etching with an etching removal of 1 um or less per surface to remove a mechanically damaged layer, then polishing both surfaces of the wafer with a stock removal of 3 um or less per surface in a double-side polishing step.

Hereinafter, the present invention will be described in detail with reference to the drawings; however, the present invention is not limited thereto.

The present invention relates to a method of manufacturing silicon wafers for semiconductors in which high flatness is required, and the method includes a dry-etching step to be performed after a grinding process.

The wafer manufacturing method of the present invention includes a grinding step, a dry-etching step, and a double-side polishing step illustrated in FIG. 1. Although optional, the wafer manufacturing method of the present invention can further include, for example, a slicing step, a chamfering step, a mirror-edge polishing step, a one-side polishing step, and a finish-cleaning step as illustrated in FIG. 1.

Each of the steps will be described in more detail below.

The slicing step is a step of, for example, cutting a silicon ingot into a disc-shaped silicon wafer by using a wire saw.

The chamfering step is a step of chamfering an outer peripheral portion of the wafer by using, for example, a whetstone on which diamond abrasive grains have been electrodeposited, to prevent cracks or splits of an edge portion of the silicon wafer obtained through slicing in the processing step. For example, by this chamfering process, a raw wafer to be ground in the subsequent grinding step can be obtained.

The grinding step is a step for the purposes of removal and flattening of the mechanically damaged layer formed on the front and back surfaces of the silicon wafer in the slicing step. In the grinding step, the front and back surfaces of the raw wafer are ground by, for example, a whetstone on which diamond has been electrodeposited, to obtain a wafer having an arithmetic surface roughness Sa per 2 µm² of 10 nm or less. Although there are two types of the grinding process, i.e., grinding one surface at a time and grinding both surfaces at the same time, either of which can be used. A #8000 (8000-grit) or higher whetstone is preferably used. The upper limit of the grit number of the whetstone is not particularly limited but can be, for example, #12000 (12000-grit) in consideration of the time for the grinding process. Although the smaller the arithmetic surface roughness Sa per 2 µm² of the wafer obtained in the grinding step the better, it can be, for example, 3 nm or more. In addition, the flatness of the wafer obtained in the grinding step can be, for example, 0.5 um or less when expressed in GBIR. On the other hand, the arithmetic surface roughness Sa per 2 µm² of the wafer obtained in the grinding step being larger than 10 nm requires more etching removal in the dry-etching step or more stock removal in the polishing step, which will be described in detail below; accordingly, good flatness after the grinding cannot be maintained.

In the dry-etching step, the wafer obtained in the grinding step is subjected to isotropic whole-surface dry-etching to remove a mechanically damaged layer introduced into each of the front and back surfaces of the wafer in the grinding step. For example, in the isotropic whole-surface dry-etching, etching gas is excited with a high frequency to generate plasma and a mechanically damaged layer formed on each of the front and back surfaces of the silicon wafer in the grinding step is removed. Here, as the process gas, for example, a gas that generates fluorine radicals (for example, CF₄, SF₆) can be used. The dry-etching step of the wafer manufacturing method of the present invention performs not local dry-etching but isotropic whole-surface dry-etching. Further, the etching removal in the isotropic whole-surface dry-etching is 1 um or less per surface. Such a small etching removal enables to maintain good flatness after the grinding. For example, deterioration of flatness in the dry-etching step can be 0.1 um or less in GBIR. Further, using the isotropic whole-surface dry-etching enables etching (removal of mechanical damage) in which no local large pits are also generated. In this case, the etching rate in the dry-etching step is preferably 0.3 um/min or less, more preferably 0.1 µm/min or more and 0.3 um/min or less. On the other hand, when local dry-etching is performed on the whole surface of the wafer or the etching removal in the isotropic whole-surface dry-etching is made larger than 1 um, good flatness after the grinding cannot be maintained. The lower limit of the etching removal in the isotropic whole-surface dry-etching is not particularly limited but the etching removal can be, for example, 0.5 nm or more per surface.

Further, as illustrated in FIG. 1, in the dry-etching step, a front-and-back surfaces oxidation treatment with ozone gas may be performed before the isotropic whole-surface dry-etching in order to remove organic substances on the front and back surfaces of the silicon wafer. By this ozone-gas treatment, organic substances adhered to the front and back surfaces of the silicon wafer is removed, and dry etching in which no unevenness is generated in the surfaces can be performed. For example, ozone gas can be introduced from the outside of an etching apparatus (chamber) into the etching apparatus to form an ozone atmosphere in the etching apparatus. Alternatively, it is possible that an oxygen atmosphere be formed in the etching apparatus and plasma be generated in the oxygen atmosphere to generate ozone. Furthermore, in the dry-etching step, as similarly illustrated in FIG. 1, after the dry etching, in order to form an oxide film as a protection film on each of the front and back surfaces of the silicon wafer, it is possible that a front-and-back surface oxidation treatment with ozone gas be performed, and alternatively it is possible that an oxygen atmosphere be formed in the etching apparatus and plasma is generated in the oxygen atmosphere to generate ozone. The technical method of this treatment is the same as that of the front-and-back surfaces oxidation treatment with ozone gas which can be performed before the dry etching. This ozone treatment forms a stable oxide film as a protection film on each of the front and back surfaces of the silicon wafer, which enables to prevent deterioration of the quality of the front and back surfaces of the silicon wafer in the following steps. It should be noted that the front-back surface oxidation treatment with ozone gas is optional and should not be necessarily performed.

In the subsequent double-side polishing step, both surfaces of the wafer are polished with a stock removal of 3 um or less per surface. For example, both surfaces of the dry-etched silicon wafer can be polished at the same time with polishing cloth and polishing slurry. Through this step, the front and back surfaces of the silicon wafer are processed into polished surfaces and at the same time are flattened. By performing the grinding step in which an Sa of 10 nm or less is obtained and performing the dry-etching step with an etching removal of 1 um, which have been described earlier, even when the stock removal in this double-side polishing step is set to 3 um or less, the front and back surfaces can be made into polished surfaces while maintaining good flatness after the grinding. These can improve productivity. The lower limit of the stock removal per surface in the double-side polishing step is not particularly limited but can be, for example, 1 um or more.

In the mirror-edge polishing step, a chamfered portion of the wafer subjected to the double-side polishing is mirrored by being subjected to mirror-finishing with polishing cloth and polishing slurry.

In the one-side polishing step, only one surface of the silicon wafer subjected to the double-side polishing is finish-polished with polishing cloth and polishing slurry.

In the finish-cleaning step, particles or metallic impurities adhered to the surface of the silicon wafer are removed. The cleaning step may be a batch type or a single-wafer spin type.

### EXAMPLES

Hereinafter, the present invention will be specifically described with reference to Example and Comparative Examples; however, the present invention is not limited thereto.

### (Example)

In Example, fifty p-type silicon single crystal wafers with a diameter of 300 mm were manufactured according to a flow diagram illustrated in FIG. 1. A method of manufacturing silicon wafers for semiconductors related to the present Example will be described below.

In the slicing step, a silicon single crystal ingot was cut into a disc-shaped silicon wafer by using a wire saw. About 20 to 30 um of a mechanically damaged layer and waviness generated during the cutting was formed on a surface of the cut silicon wafer.

In the chamfering step, an outer peripheral portion of the cut silicon wafer was chamfered with a 3000-grit whetstone on which diamond has been electrodeposited, to form a chamfered shape and simultaneously prevent cracks or splits in the wafer manufacturing steps. By this chamfering process, a raw wafer to be ground in the subsequent grinding step was obtained.

In the grinding step, the mechanically damaged layer formed on the surface of the silicon wafer in the slicing step was removed and flattened. Specifically, a #8000 (8000-grit) whetstone on which diamond has been electrodeposited was used to grind one surface of the front and back surfaces of the raw wafer at a time. The grinding removal was set to 15 um per surface. The wafer after the grinding in the grinding step had a maximum value of arithmetic surface roughness Sa per 2 µm² of 10 nm and simultaneously had flatness of 0.5 um or less in GBIR. In addition, the mechanically damaged layer formed on each of the front and back surfaces of the silicon wafer in the grinding step was 0.1 um or less. The arithmetic surface roughness Sa per 2 µm² was measured with 1-mm probing by using SJ-410 of Mitsutoyo. Further, GBIR, which is an indicator of flatness, was measured with WaferSight manufactured by KLA.

In the dry-etching step, the mechanically damaged layer formed on each of the front and back surfaces of the silicon wafer in the grinding step was removed by the isotropic whole-surface dry-etching using plasma of etching gas generated through excitation with a high frequency. Here, as the process gas, CF₄, which is a gas that generates fluorine radicals, was used. The etching removal in the dry-etching step was set to 1 um or less per surface, and the etching rate was set to 0.3 um/min or less. Further, before the whole-surface dry-etching, ozone gas was introduced into an etching apparatus to perform the front-and-back surface oxidation treatment with ozone gas for decomposition and removal of organic substances on the front and back surfaces of the silicon wafer. Furthermore, after the whole-surface dry-etching, ozone gas was introduced into the etching apparatus to perform the front-and-back surface oxidation treatment with ozone gas for formation of an oxide film as a protection film on each of the front and back surfaces of the silicon wafer. The concentration of the ozone gas for decomposing organic substances adhered to the front and back surfaces of the wafer and the concentration of the ozone gas for oxidizing the front and back surfaces of the silicon wafer were set to 20 ppm. Deterioration of flatness in the dry-etching step was 0.1 um or less in GBIR.

In the double-side polishing step, the front and back surfaces of the dry-etched silicon wafer were polished at the same time with polishing cloth and polishing slurry. Flattening was performed along with both surfaces of the silicon wafer being processed into polished surfaces. The stock removal in the double-side polishing step was set to 3 um per surface, and flatness of the silicon wafer after the double-side polishing became 0.5 um in GBIR.

In the mirror-edge polishing step, a chamfered portion of the wafer subjected to the double-side polishing was mirror-finished with polishing cloth and polishing slurry. Through the mirror-edge polishing, the chamfered portion could be also made to have a mirror surface with no mechanical damage.

In the finish-polishing step, only one surface of the front and back surfaces of the silicon wafer subjected to the double-side polishing was finish-polished with polishing cloth and polishing slurry. Through the finish polishing, a smooth surface being a Haze surface was obtained.

In the finish-cleaning step, particles or metallic impurities adhered to the surface of the silicon wafer were removed. Here, batch-type cleaning was performed with SC1 and SC2 for chemical solutions.

### (Comparative Example 1)

In Comparative Example 1, the same number of semiconductor wafers as in Example was manufactured in the following procedures.

The slicing step and the chamfering step were the same as in Example.

The grinding step was the same as in Example except for the use of a 3000-grit whetstone. The wafer after the grinding in the grinding step had an arithmetic surface roughness Sa per 2 µm² of 50 nm and simultaneously had flatness of 0.5 um in GBIR. In addition, the mechanically damaged layer formed on each of the front and back surfaces of the silicon wafer in the grinding step was 0.5 um.

Here, in the etching step, removal of the mechanically damaged layer formed on each of the front and back surfaces of the silicon wafer in the grinding step was performed by a mixed-acid method with HF and HNO₃ as wet etching using chemical solutions. The mixed acid used had a composition of HNO₃ volume of 2 with respect to HF volume of 1. The etching removal in the mixed-acid etching was set to 10 um per surface. The deterioration amount of GBIR after the mixed-acid etching was about 3 to 4 um.

In the double-side polishing step, both surfaces of the mixed-acid etched silicon wafer were polished. To modify the GBIR deteriorated by the mixed-acid etching with the double-side polishing, 15 um of stock removal per surface was required, and flatness of the silicon wafer after the double-side polishing also became 1.3 um in GBIR.

The mirror-edge polishing step, the one-side polishing step, and the finish-cleaning step were the same as in Example.

### (Comparative Example 2)

In Comparative Example 2, the same number of semiconductor wafers as in Example was manufactured in the following procedures.

The slicing step, the chamfering step, and the grinding step were the same as in Comparative Example 1.

The etching step was performed by alkali etching with NaOH as a chemical solution. The alkali-etching removal was set to 10 um per surface. In the alkali etching, surface roughness deteriorated and deep pits were formed.

In the double-side polishing step, both surfaces of the alkali-etched silicon wafer were polished. To modify the surface roughness deteriorated by the alkali etching and remove the deep pits, 13 um of stock removal per surface was required, and flatness of the silicon wafer after the double-side polishing also became 0.9 um in GBIR.

The mirror-edge polishing step, the one-side polishing step, and the finish-cleaning step were the same as in Example.

### (Comparative Example 3)

Comparative Example 3 was conducted in the same manner as Example such that the same number of semiconductor wafers as in Example was manufactured, except that the grinding step was performed in the same manner as that of Comparative Example 1, and that the stock removal was set to 10 um per surface in the double-side polishing step for improvement of surface roughness.

Flatness of the silicon wafer after the double-side polishing became 0.7 um in GBIR.

For the above-described Example and Comparative Examples 1, 2, and 3, the processing conditions of each of the steps and the states of the wafer after each of the steps are summarized in Table 1 below.

**[Table 1]**

| Step | | Example | Comparative Example 1 | Comparative Example 2 | Comparative Example 3 |
|---|---|---|---|---|---|
| Slicing Step | | Wire Saw | Wire Saw | Wire Saw | Wire Saw |
| Chamfering Step | Whetstone | #3000 | #3000 | #3000 | #3000 |
| Grinding Step | Whetstone | #8000 | #3000 | #3000 | #3000 |
| | Grinding Removal (per surface) | 15 µm | 15 µm | 15 µm | 15 µm |
| | Surface Roughness (Sa) | 10 nm or less | 50 nm | 50 nm | 50 nm |
| | GBIR after Grinding | 0.5 µm or less | 0.5 µm | 0.5 µm | 0.5 µm |
| Etching | | Dry Etching | Mixed-Acid Etching | Alkali Etching | Dry Etching |
| | One-Side Etching Removal | 1 µm or less | 10 µm | 10 µm | 1 µm |
| | Surface Roughness (Ra) | 4 nm | 0.5 µm | 1 µm | 20 nm |
| | Deterioration Amount of GBIR | Δ0.1 µm or less | Δ3.0 to 4.0 µm | Δ0.1 µm | Δ0.1 µm or less |
| | GBIR after Etching | 0.6 µm or less | 3.5 to 4.5 µm | 0.6 µm | 0.6 µm or less |
| Double-Side Polishing Step | Stock Removal | 3 µm | 15 µm | 13 µm | 10 µm |
| | Deep Pits Generated | None | None | None | None |
| | GBIR after Double-Side Polishing | 0.5 µm | 1.3 µm | 0.9 µm | 0.7 µm |
| One-Side Polishing Step | GBIR after One-Side Polishing | 0.5 µm | 1.3 µm | 0.9 µm | 0.7 µm |
| Finish-Cleaning Step | Cleaning Solution | SC1 followed by SC2 | SC1 followed by SC2 | SC1 followed by SC2 | SC1 followed by SC2 |

As apparent from Table 1, in Example, by obtaining a wafer having an arithmetic surface roughness Sa per 2 µm² of 10 nm or less through the grinding step, subjecting the wafer to the isotropic whole-surface dry-etching with an etching removal of 1 um or less per surface to remove a mechanically damaged layer, then polishing both surfaces of the wafer with a stock removal of 3 um or less per surface in the double-side polishing step, the mechanically damaged layer could be removed without deteriorating good flatness after the grinding, which enabled to manufacture a wafer having high flatness with high productivity.

On the other hand, in Comparative Example 1 in which the mixed-acid etching was performed, GBIR, which is an indicator of flatness, was deteriorated, failing to maintain good flatness after the grinding. In Comparative Example 2 in which the alkali etching was performed, a large stock removal was required for removal of the deep pits, and productivity also declined.

Further, in Comparative Example 3 in which the arithmetic surface roughness Sa per 2 µm² was made larger than 10 nm through the grinding step, more stock removal was required in the double-side polishing step, so that productivity declined and good flatness after the grinding also could not be maintained.

It should be noted that the present invention is not limited to the above-described embodiments. The embodiments are just examples, and any examples that substantially have the same feature and demonstrate the same functions and effects as those in the technical concept disclosed in claims of the present invention are included in the technical scope of the present invention.

## Claims

1. A silicon wafer manufacturing method comprising:
a grinding step of grinding front and back surfaces of a raw wafer to obtain a wafer having an arithmetic surface roughness Sa per 2 µm² of 10 nm or less;
a dry-etching step of subjecting the wafer obtained in the grinding step to isotropic whole-surface dry-etching with an etching removal of 1 um or less per surface to remove a mechanically damaged layer introduced into each of front and back surfaces of the wafer in the grinding step; and
a double-side polishing step of, after the dry-etching step, polishing both surfaces of the wafer with a stock removal of 3 um or less per surface.

2. The silicon wafer manufacturing method according to claim 1, wherein in the dry-etching step, an etching rate is 0.3 um/min or less.

3. The silicon wafer manufacturing method according to claim 1 or 2, wherein in the dry-etching step, a front-and-back surfaces oxidation treatment with ozone gas is performed as a pre-treatment of the isotropic whole-surface dry-etching.

4. The silicon wafer manufacturing method according to any one of claims 1 to 3, wherein in the dry-etching step, a front-and-back surfaces oxidation treatment with ozone gas is performed as a post-treatment of the isotropic whole-surface dry-etching.
